# EUROPÄISCHE PATENTSCHRIFT

(11) **EP 0 856 742 B1**
(45) Veröffentlichungstag und Bekanntmachung des Hinweises auf die Patenterteilung: **13.07.2005**
(21) Anmeldenummer: 98200134.9
(22) Anmeldetag: 20.01.1998
(51) Int. Cl.: G01R 33/34

(54) **MR-Gerät mit einer HF-Spulenanordnung**
MR apparatus with an RF coil
Appareil de RM avec une bobine RF

(30) Priorität: 23.01.1997 DE 19702256
(43) Veröffentlichungstag der Anmeldung: 05.08.1998
(73) Patentinhaber: Philips Intellectual Property & Standards GmbH, 20099 Hamburg (DE); Koninklijke Philips Electronics N.V., 5621 BA Eindhoven (NL)
(72) Erfinder: Leussler, Christoph, c/o Philips Patentverw.GmbH, 22335 Hamburg (DE)
(74) Vertreter: Volmer, Georg, Dipl.-Ing.

(56) Entgegenhaltungen:
- WO-A-96/34296
- US-A- 5 196 797
- J. TROPP: "The Theory of the Bird-Cage Resonator" JOURNAL OF MAGNETIC RESONANCE, Bd. 82, 1989, Seiten 51-62, XP000009445
- E.K. INSKO, J.S. LEIGH: "A Double Discrete Cosine Quadrature Coil Design" JOURNAL OF MAGNETIC RESONANCE, SERIES A, Bd. 104, 1993, Seiten 78-82, XP000383366

## Beschreibung

Die Erfindung betrifft ein MR-Gerät mit einer dem Empfang von MR-Signalen aus einem Untersuchungsbereich dienenden MR-Spulenanordnung nach dem Oberbegriff des Anspruchs 1. Eine derartige MR-Spulenanordnung ist aus der US-PS 4 680 548 bekannt. Deren beide Leiterschleifen haben in der Regel die Form zweier gleichgroßer koaxialer Kreise, die durch die Leiter miteinander verbunden werden. Dieser Aufbau verleiht der MR-Spulenanordnung das Aussehen eines Vogelkäfigs (engl.: birdcage), weshalb diese Spulenanordnung in der Fachwelt oft auch als "Birdcage-Spule" bezeichnet wird.

Eine solche Birdcage-Spule hat halb soviel verschiedene Resonanzfrequenzen wie sie Leiter aufweist. Jeder Resonanzfrequenz ist ein unterschiedlicher Resonanzmodus zugeordnet, wobei die Birdcage-Spule stets in dem Resonanzmodus betrieben wird, in dem sich im Innern der Spule eine möglichst homogene Feldverteilung (bei Betrieb als Sendespule) oder eine ortsunabhängige konstante Empfindlichkeit (bei Betrieb als Empfangsspule) ergibt. Diese Ortsunabhängigkeit der Empfindlichkeit - insbesondere in einer zu der Spulenachse senkrechten Ebene - ist ein Vorteil, weil sie die Rekonstruktion eines MR-Bildes aus den von der MR-Spulenanordnung empfangenen MR-Signalen erleichtert.

Aus der US-B 5,196,797 ist der Betrieb einer solchen Birdcage-Spule als Quadraturspule bekannt, wobei an zwei um 90° gegeneinander versetzten Leitern um 90° gegeneinander versetzte Spannungen abgegriffen werden, die durch eine geeignete Kombinationsschaltung miteinander kombiniert werden können. Wenn im Idealfall die beiden Ausgänge der Quadraturspule von einander entkoppelt sind ergibt sich eine Verbesserung des Signal/Rauschverhältnisses um 3 dB. In der Praxis sind die Ausgänge aber nicht voneinander entkoppelt, und es ergibt sich eine geringere - oder gar keine - Verbesserung. Die fehlende Entkopplung äußert sich - wie bei zwei identischen, miteinander gekoppelten Resonatoren ― darin, daß sich bei einem Resonanzmodus ein Resonanzspektrum mit zwei Resonanzfrequenzen ergibt, deren Abstand voneinander von der Stärke der Kopplung abhängt. Die US-B 5,196,797 beschreibt nun ein Verfahren, wie man trotz dieser nicht idealen Verhältnisse wieder zu einer einzigen Resonanzfrequenz bei den vorgegebenen beiden Resonanzmoden und einem verbesserten Signal/Rausch-verhältnis kommen kann. - Daneben gibt es "Spulen-Arrays", die sich aus mehreren, meist ebenen Teilspulen zusammensetzen, die ein noch besseres Signal/Rauschverhältnis aufweisen als eine solche Birdcage-Spule.

Aufgabe der vorliegenden Erfindung ist es daher, ein MR-Gerät der eingangs genannten Art in dieser Hinsicht zu verbessern. Diese Aufgabe wird erfindungsgemäß durch die im Kennzeichen des Anspruchs 1 angegebenen Maßnahmengelöst.

Die Erfindung beruht auf der Erkenntnis, daß bei einer bestimmten Bemessung der Kapazitäten in den beiden Leiterschleifen und in den sie verbindenden Leitern die MR-Spulenanordnung alle Resonanzmoden nur noch eine einzige Resonanzfrequenz aufweien und daß bei dieser Resonanzfrequenz die einzelnen Maschen, aus denen sich die MR-Spulenanordnung zusammensetzt (eine Masche umfaßt zwei benachbarte Leiter und die dazwischen befindlichen Abschnitte der beiden Leiterschleifen) voneinander entkoppelt sind. Wegen der Entkopplung können die von den einzelnen Maschen empfangenen Signale unabhängig voneinander zu MR-Bildern verarbeitet werden - wie bei einem Spulen-Array - wobei aus den einzelnen MR-Bildern ein gemeinsames MR-Bild rekonstruieren kann, das insbesondere in den den Maschen benachbarten Bereichen im Innern der Spulenanordnung ein besonders hohes Signal/Rauschverhältnis aufweist. Die einzelnen Maschen weisen eine stark ortsabhängige Empfindlichkeit auf, d.h. sie haben eine sehr hohe Empfindlichkeit für Signale aus Bereichen, die der Masche benachbart sind, und eine relativ geringe Empfindlichkeit für weiter entfernte Bereiche. Um ein MR-Bild mit diesen hohen Signal/Rauschverhältnis im gesamten Außenbereich zu erhalten, ist es daher notwendig, die von den einzelnen Maschen erhaltenen MR-Daten bzw. MR-Bilder miteinander zu kombinieren, um ein MR-Gesamtbild zu erhalten. Der Begriff "MR-Gesamtbild" ist allerdings breit zu interpretieren. Darunter ist nicht nur eine Repräsentation der räumlichen Verteilung sondern auch der spektroskopischen Verteilung zu verstehen.

Demgemäß wird bei einer MR-Spulenanordnung mit zwei gleichartigen, Kapazitäten enthaltenden Leiterschleifen, die über mehrere, Kapazitäten enthaltende Leiter miteinander verbunden sind, ein verbessertes Signal/Rauschverhältnis dadurch erreicht, daß zum Empfangen von mehreren MR-Signalen mit einer innerhalb des von der Spulenanordnung umschlossenen Bereichs ortsabhängigen Empfindlichkeit die Kapazitäten so bemessen sind, daß sich lediglich eine einzige Resonanzfrequenz ergibt.

Eine Weiterbildung der Erfindung ist in Anspruch 2 angegeben. Da hierbei für jede Masche ein gesonderter Verarbeitungskanal vorgesehen ist, hat das aus den MR-Daten der einzelnen Verarbeitungskanäle rekonstruierte MR-Gesamtbild das bestmögliche Signal/Rauschverhältnis. Allerdings ergibt sich insofern ein hoher Aufwand als für jede Masche ein Verarbeitungskanal erforderlich ist.

Eine andere Ausgestaltung der Erfindung ist in Anspruch 3 angegeben. Hierbei ist nur für jeweils zwei Maschen ein Verarbeitungskanal erforderlich, weil die Signale jeweils zweier benachbarter Maschen über die Kombinationsschaltung zusammengefaßt werden. Allerdings wird das bestmögliche Signal/Rauschverhältnis nur an einigen Stellen des MR-Gesamtbildes erreicht.

Wie bereits erwähnt, weisen die einzelnen Maschen eine stark ortsabhängige Empfindlichkeit auf, die für die Rekonstruktion eines optimalen MR-Gesamtbildes ermittelt werden muß. Es ist bekannt, daß man zu diesem Zweck eine MR-Spule benötigt, die im gesamten Untersuchungsbereich eine vorgegebene, weitgehend ortsunabhängige Empfindlichkeit aufweist. Demgemäß sieht eine Weiterbildung der Erfindung vor, daß Umschalteinheiten zur Umschaltung der Kapazitäten der MR-Spulenanordnung zwischen einer ersten und einer zweiten Betriebsart vorgesehen sind, wobei die MR-Spulenanordnung in der ersten Betriebsart lediglich eine einzige Resonanzfrequenz aufweist und in der zweiten Betriebsart mehrere Resonanzmodes mit unterschiedlichen Resonanzfrequenzen, wobei der Resonanzmodus mit örtlich homogener Spulen-Empfindlichkeit bei einer Resonanzfrequenz liegt, die der einzigen Resonanzfrequenz in der ersten Betriebsart entspricht.

In der ersten Betriebsart wirkt die MR-Spulenanordnung somit wie ein Spulen-Array - mit stellenweise hoher, insgesamt aber stark ortsabhängiger Empfindlichkeit und in der zweiten Betriebsart wie eine übliche Birdcage-Spule - mit einer weitgehend ortsunabhängigen mittleren Empfindlichkeit.

Die Erfindung wird nachstehend anhand der Zeichnungen näher erläutert. Es zeigen:
- Fig. 1: ein Blockschaltbild eines erfindungsgemäßen MR-Gerätes
- Fig. 2: den Aufbau der dabei benutzten MR-Spulenanordnung
- Fig. 3: ein Diagramm aus dem sich die verschiedenen Resonanzfrequenzen bzw. Resonanzmodes ergeben
- Fig. 4: eine erste Möglichkeit der Signalverarbeitung
- Fig. 5: eine zweite Möglichkeit der Signalverarbeitung und
- Fig. 6: einen Teil einer zwischen einer ersten und einer zweiten Betriebsart umschaltbaren MR-Spulenanordnung

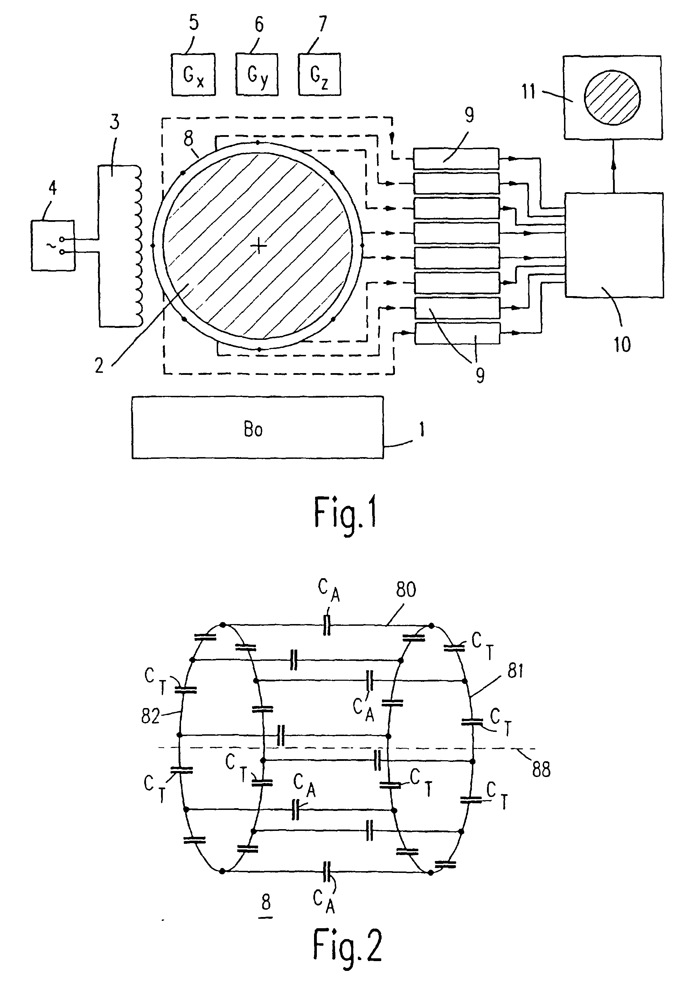

In Fig. 1 ist mit 1 ein Hauptfeldmagnet bezeichnet, der in einem Untersuchungsbereich 2, in dem sich ein Untersuchungsobjekt befinden kann, ein homogenes stationäres Magnetfeld erzeugt, das eine Stärke von z.B. 1,5 Tesla aufweisen kann. Mit 3 ist eine Hochfrequenzspule bezeichnet, die an einen Hochfrequenzsender 4 angeschlossen ist und die in dem Untersuchungsbereich zwei magnetische Hochfrequenzimpulse mit der durch die Stärke des Magnetfeldes vorgegebenen Larmorfrequenz aufweist. Bei einem Magnetfeld von 1,5 Tesla beträgt diese Frequenz ca. 63,8 MHz.

Weiterhin sind drei Gradientenspulen 5,6 und 7 vorgesehen, mit deren Hilfe im Untersuchungsbereich Magnetfelder erzeugt werden können, die in der gleichen Richtung verlaufen, wie das vom Hauptfeldmagneten erzeugten stationäre Magnetfeld, die jedoch einen Gradienten in x,y- oder z-Richtung aufweisen. Mit Hilfe dieser Gradientenspulen kann die durch die Hochfrequenzspule 3 erzeugte Anregung der Kernmagnetisierung auf einen bestimmten räumlichen Bereich beschränkt werden, bzw. es können die entstehenden MR-Signale dadurch in ihrer Phase oder Frequenz kodiert werden, so daß MR-Bilder des Untersuchungsbereichs erzeugt werden können.

Die entstehenden MR-Signale werden von einer MR-Spulenanordnung 8 empfangen. Diese MR-Spulenanordnung ist in acht Abschnitte bzw. Maschen unterteilt, von denen jede - wie durch gestrichelte Linien angedeutet - an einen gesonderten Verarbeitungskanal 9 angeschlossen ist. In einem solchen Verarbeitungskanal 9 wird das MR-Signal demoduliert, dekodiert und digitalisiert und es werden - z.B. mittels einer Fourier-Transformation - MR-Daten erzeugt, die die Kernmagnetisierungsverteilung in dem von der jeweiligen Masche erfaßten Bereich darstellen, d.h. je ein MR-Bild dieses Bereichs. Mittels einer Rekonstruktionseinheit 10 können diese MR-Einzelbilder zu einem MR-Gesamtbild zusammengefügt werden, das die Kernmagnetisierungsverteilung in dem von der MR-Spulenanordnung 8 umschlossenen Bereich darstellt. Das Signal/Rauschverhältnis im Zentrum dieses MR-Gesamtbildes hat praktisch den gleichen Wert wie ein von einer Birdcage-Spule mit gleicher Geometrie aufgenommenes MR-Bild; in den Randbereichen ist das Signal/Rauschverhältnis jedoch um einen Faktor 2 bis 4 besser.

In Fig. 2 ist die in Fig. 1 nur schematisch angedeutete MR-Spulenanordnung 8 im einzelnen dargestellt. Diese Spulenanordnung ist rotationssymmetrisch bezüglich einer Symmetrieachse 88 aufgebaut und umfaßt zwei gleich große, vorzugsweise kreisförmige Leiterschleifen 81 und 82, die koaxial zur Symmetrieachse 88 und in zu dieser Achse senkrechten Ebenen angeordnet sind. Die beiden Leiterschleifen 81 und 82 sind über beispielsweise acht (oder eine andere gerade Zahl) Leiter 80 elektrisch miteinander verbunden. In jeden dieser geraden Leiter befindet sich ein Kondensator mit der Kapazität C_{A}, und ebenso ist in die zwischen je zwei Leitern 80 befindlichen Abschnitte der Leiterschleifen 81 und 82 je ein Kondensator mit der Kapazität C_{T} eingefügt.

Die Leiter und Leiterschleifen können aus 10 mm breiten Kupferstreifen bestehen, die auf einen geeigneten isolierenden Trägerkörper, z.B. aus Plexiglas aufgebracht sind. Bei einer Kopfspule dieser Art können die Leiter 80 eine Länge von 120 mm und die Leiterschleifen 81,82 einen Durchmesser von 250 mm haben. MR-Spulen mit diesem geometrischen Aufbau sind an sich aus der US-PS 4 680 548 bekannt.

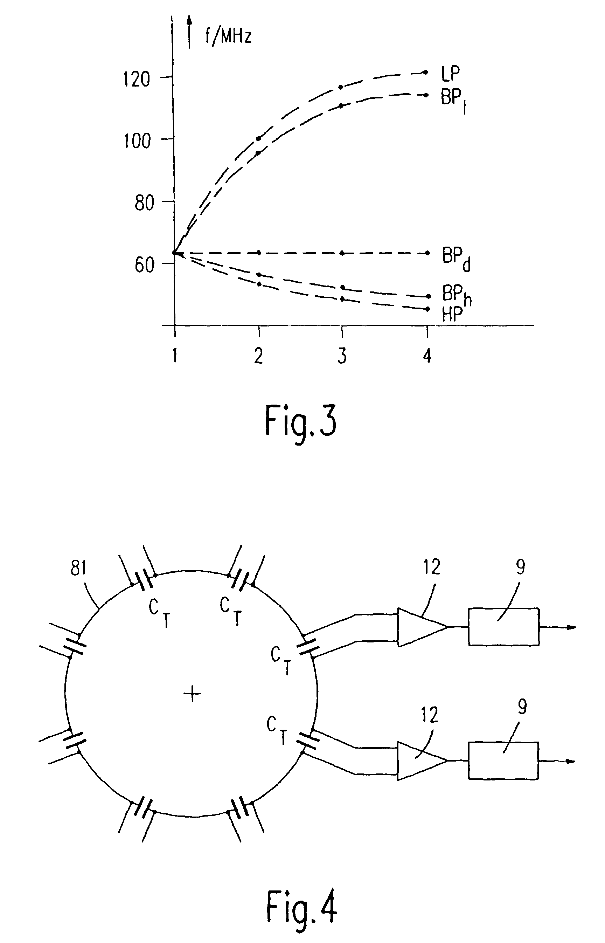

Das elektrische Verhalten dieser Spulen wird im folgenden anhand von Fig. 3 erläutert, die die verschiedenen Resonanzfrequenzen (Ordinate) und Resonanzsmodes (Abszisse) darstellt. Grundsätzlich gilt, daß eine derartige Spule halb soviele Resonanzmodes bzw. Resonanzfrequenzen aufweist, wie Leiter 80 vorhanden sind. Im Ausführungsbeispiel mit acht Leitern gibt es also vier verschiedene Resonanzfrequenzen und vier verschiedene Resonanzmodes (mit unterschiedlichen Feldverteilung bzw. mit unterschiedlicher ortsabhängiger Empfindlichkeit). Die zu einer bestimmten Bemessung der Spule gehörenden Resonanzfrequenzen und Resonanzmodes sind durch gestrichelte Kurven miteinander verbunden. Man unterscheidet zwischen verschiedenen Spulentypen:
a) Der Tiefpaßtyp zeichnet sich dadurch aus, daß die Leiterschleifen 81, 82 keine Kapazitäten C_{T} aufweisen, sodaß hier nur die örtlich verteilten Induktivitäten der einzelnen Abschnitte der Leiterschleifen wirksam sind. Es gibt vier verschiedene Resonanzfrequenzen, wobei mit der niedrigsten Resonanzfrequenz ein Resonanzsmodus verknüpft ist, bei dem sich eine homogene Feldverteilung bzw. Empfindlichkeit in dem von der Spule umschlossenen Bereich gibt und der deshalb empfohlen wird. Die anderen Resonanzmodes bei den höheren Resonanzfrequenzen haben weniger geeignete Feldverteilungen und werden daher nicht benutzt. In Fig. 3 ist eine Kurve für diesen Typ mit LP bezeichnet. Bei den angegebenen geometrischen Parametern der Spule ergibt sich für diesen Typ die niedrigste Resonanzfrequenz bei 63,8 MHz, wenn die Kapazität C_{A} in den Leitern 80 einen Wert von 18 pF hat.
b) Der Hochpaßtyp entsteht dadurch, daß nur in den Leiterschleifen 81 und 82 Kondensatoren vorhanden sind, während die Leiter 80 keinen Kondensator enthalten und aus durchgehenden Leitern bestehen, sodaß nur die örtlich verteilten Induktivitäten der einzelnen Leiter wirksam sind. Dieser Typ weist (bei acht Leitern) ebenfalls vier Resonanzfrequenzen mit vier Resonanzmodes auf, wobei jedoch der bevorzugte Resonanzsmodus bei der höchsten Frequenz liegt. Die sich für diesen Typ ergebende Kurve ist in Fig. 3 mit HP bezeichnet, wobei sich bei den angegebenen Abmessungen der Spule eine höchste Resonanzfrequenz bei 63,8 MHz ergibt, wenn die Kapazität C_{T} einen Wert von 61 pF hat.
c) Der Bandpaßtyp hat - wie in Fig. 2 dargestellt - sowohl in den Leiterschleifen als auch in den Leitern Kondensatoren. Gemäß der genannten US-PS kann man auch diesem Bandpaßtyp ein "Hochpaß"- oder "Tiefpaß"-Verhalten zuordnen, je nach dem, ob die Leiter mit den Kapazitäten C_{A} oder die Leiterschleifenabschnitte mit den Kapazitäten C_{T} sich induktiv verhalten (während sich der jeweils andere Teil kapazitiv verhält).
   In Fig. 3 ist die Kurve für einen solchen Bandpaßtyp mit Tiefpaßverhalten BP, bezeichnet, wobei der bevorzugte Resonanzmodus (mit örtlich homogener Empfindlichkeit) bei der niedrigsten Resonanzfrequenz liegt. Bei den angegebenen Abmessungen der Spule liegt diese Resonanzfrequenz bei 63,8 MHz, wenn die Kapazität C_{A} einen Wert von 21 pF und die Kapazität C_{T} einen Wert von 420 pF hat.
   Der Bandpaßtyp mit Hochpaßverhalten ist in Fig. 3 durch die Kurve BPₕ dargestellt. Der bevorzugte Resonanzmodus liegt für diesen Typ bei der höchsten Resonanzfrequenz. Diese liegt bei den vorgegebenen Abmessungen der Spule bei 63,8 MHz, wenn C_{A} einen Wert von 325 pF hat und C_{T} einen Wert von 65 pF aufweist.

Die Erfindung stellt zwar auch einen Bandpaßtyp dar, weil sie sowohl in den Leitern als auch in den Leiterschleifen Kapazitäten enthält, jedoch sind die Kapazitäten so bemessen, daß sich weder ein Hochpaßverhalten noch ein Tiefpaßverhalten ergibt, sondern das in Fig. 3 durch die Gerade BP_{d} bezeichnete Verhalten bei dem alle Resonanzmodes bei der gleichen Frequenz auftreten. Dieses Verhalten stellt sich bei der angegebenen Bemessung der Spule bei 63,8 MHz dann ein, wenn die Kapazität C_{A} einen Wert von 118 pF und die Kapazität Cᵣ einen Wert von 72 pF aufweist.

In einer Veröffentlichung von Tropp (Proceedings of the 11th SMRM, p. 4009, 1992) wird dieses Verhalten als entartet (degenerate) bezeichnet. Der Erfinder hat jedoch erkannt, daß bei dieser Bemessung die einzelnen Maschen, die von zwei benachbarten Leitern und den sie verbindenden Abschnitten der Leiterschleifen 81 und 82 gebildet werden, von den benachbarten Leiterschleifen entkoppelt sind. Diese Eigenschaft erlaubt es, die Spulenanordnung wie ein Spulen-Array zu betreiben und ein MR-Gesamtbild aus den MR-Bildern der einzelnen Maschen zu rekonstruieren. Die einzelnen Maschen haben für die in ihrer Nähe liegenden Teile des Untersuchungsbereiches eine hohe Empfindlichkeit, aber nur eine geringe Empfindlichkeit für die weiter entfernt liegenden Teile. Setzt man demgemäß ein MR-Gesamtbild aus den MR-Einzelbildern der einzelnen Maschen zusammen, ergibt sich - im Vergleich zu einer konventionell betriebenen Birdcage-Spule im Außenbereich ein um einen Faktor 2 bis 4 erhöhtes Signal/Rauschverhältnis, während es im Zentrum den gleichen Wert hat wie bei einer konventionellen Spule.

Fig. 4 zeigt nun, wie man die Signale aus den Maschen abgreifen kann. Danach werden die Signale an jedem der Kondensatoren C_{T} mit einem hochohmigen Verstärker abgegriffen. Da diese Kondensatoren jeweils nur einer Masche zugeordnet sind, repräsentiert die Spannung an diesem Kondensator das in der Masche induzierte MR-Signal. Die an den Kondensatoren C, abgegriffenen Signale werden über je einen der Verstärker 12 den Verarbeitungskanälen 9 zugeführt. In Fig. 2 ist dies lediglich für zwei Maschen dargestellt, doch werden die Signale aller Maschen auf diese Weise verarbeitet.

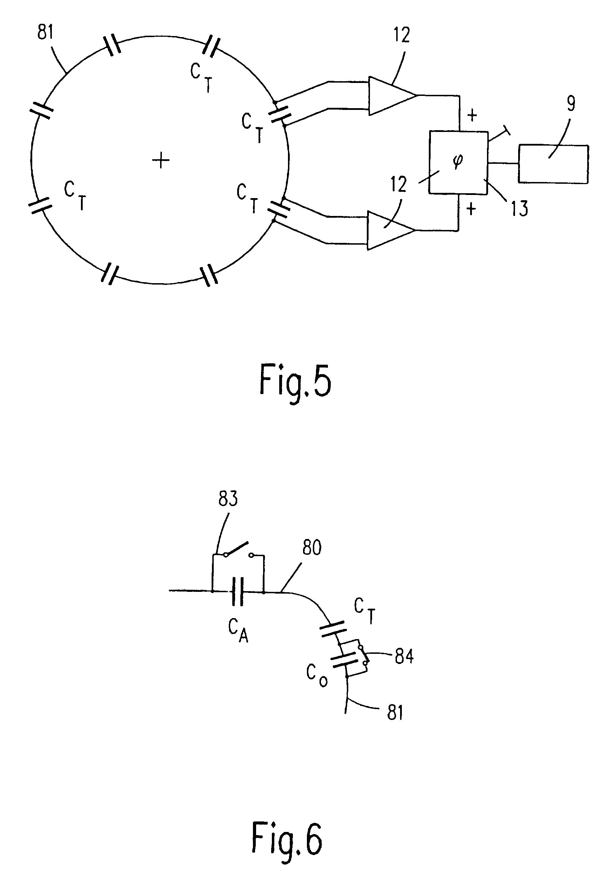

Nachteilig an diesem Verarbeitungsprinzip ist, daß acht Verarbeitungskanäle erforderlich sind (falls die MR-Spule acht Maschen bzw. acht Leiter 80 aufweist). Ein MR-Gerät, das weniger Verarbeitungskanäle aufweist, kann die MR-Signale also nicht auf diese Weise verarbeiten. In Fig. 5 ist daher eine Lösung dargestellt, die mit halb soviel Kanälen auskommt. Dabei werden die Signale von jeweils zwei benachbarten Maschen über je einen Verstärker 12 den Eingängen einer Kombinationsschaltung 13 zugeführt. Die Kombinationsschaltung addiert die an ihren beiden Eingängen anliegenden Signale mit einer einstellbaren Phasenverschiebung. Das Ausgangssignal der Kombinationsschaltung 13 wird von einem Verarbeitungskanal 9 verarbeitet, so daß für acht Maschen in diesem Fall lediglich vier Verarbeitungskanäle erforderlich sind. Das aus den MR-Daten der einzelnen Verarbeitungskanäle zusammengesetzte MR-Gesamtbild hat das beste erzielbare Signal/Rauschverhältnis in Bereichen, deren Lage von der Phase abhängt, mit der die Signale zweier Maschen kombiniert werden. Durch Verändern der Phasenlage kann daher dieses Optimum in gewünschte Bereiche verschoben werden.

In vielen Fällen ist es erwünscht, daß man neben einem Spulen-Array mit stark ortsabhängiger Empfindlichkeit noch eine Spule zur Verfügung hat, die im Untersuchungsbereich eine weitgehend homogene Empfindlichkeit aufweist, wie z.B. eine konventionelle Birdcage-Spule. Mit einer derartigen Spule könnte man den Empfindlichkeitsverlauf des Spulen-Arrays messen wie in dem europäischen Patent EP-695 947 beschrieben.

Zu diesem Zweck werden alle Kapazitäten in den Leitern und in den Leiterschleifen mittels Umschalteinheiten umgeschaltet. Dies ist in Fig. 6 für eine der Kapazitäten in den Leitern 80 und für eine der Kapazitäten in den Leiterschleifen 81 dargestellt. Danach wird die Kapazität C_{A} durch einen steuerbaren Schalter 83 überbrückt - z. B. eine Pin-Diode, die die Kapazität kurzschließt, wenn der Schalter 83 geschlossen wird. In Serie zu den einzelnen Kapazitäten C_{T} ist jeweils noch ein Kondensator C_{O} vorgesehen, der durch einen Schalter 84 überbrückt wird.

In einer ersten Betriebsart ist der Schalter 83 geöffnet und der Schalter 84 geschlossen. Es sind dann die Kapazitäten C_{A} und C_{T} wirksam, und es ergibt sich der erfindungsgemäße Betrieb, bei dem benachbarte Maschen voneinander entkoppelt sind. - In einer zweiten Betriebsart ist der Schalter 83 geschlossen und der Schalter 84 geöffnet. Dadurch wird die Kapazität C_{A} kurzgeschlossen (so daß sich ein Birdcage mit Hochpaßverhalten ergibt) und die Kapazität C₀ erscheint jeweils in Serie zur Kapazität C_{T}. Wenn die Kapazität C₀ so bemessen ist, daß die Serienschaltung einen Wert von 61 pF aufweist, liegt die höchste Resonanzfrequenz (mit dem erwünschten Resonanzmodus) bei 63,8 MHz.

Somit ist es möglich, durch Umschalten der Kapazitäten zwei MR-Spulen mit unterschiedlichen elektrischen Verhalten zu erhalten. Man kann von einem Spulentyp zum anderen übergehen, ohne die Spulen austauschen zu müssen.

Die Erfindung wurde vorstehend anhand eines Ausführungsbeispiels mit acht Leitern 80 bzw. acht Maschen erläutert. Es ist aber auch eine andere gerade Zahl von Leitern bzw. Maschen möglich, z.B. 16. Weiterhin wurde von kreisförmigen Leiterschleifen ausgegangen, jedoch sind auch andere Formen möglich, z.B. vieleckige (mit soviel Ecken, wie Leitern vorhanden sind) oder elliptische. Die Leiterschleifen müssen nicht notwendigerweise geschlossen sein und es kann eine der Maschen ggf. entfallen. Eine der beiden Leiterschleifen kann auch zusätzliche Leiterstrukturen aufweisen, was bei Anwendungen im Kopfbereich zu einer Feldkonzentration führen kann.

## Patentansprüche

1. MR-Gerät mit einer dem Empfang von MR-Signalen aus einem Untersuchungsbereich (2) dienenden MR-Spulenanordnung (8), die zwei gleichartige, Kapazitäten (C_{T}) enthaltende Leiterschleifen (81,82) umfaßt, die über mehrere, Kapazitäten (C_{A}) enthaltende Leiter (80) miteinander verbunden sind,
wobei je zwei benachbarte Leiter und die dazwischen befindlichen Abschnitte der Leiterschleifen eine Masche bilden,
**dadurch gekennzeichnet, daß** die Kapazitäten (C_{T}, C_{A}) so bemessen sind, daß sich für alle Resonanzmodes der MR-Spulenanordnung (8) lediglich eine einzige Resonanzfrequenz ergibt,
daß wenigstens zwei Verarbeitungskanäle (9) vorgesehen sind zum getrennten Verarbeiten der in den verschiedenen, wenigstens zwei Maschen auftretenden MR-Signale und zur Erzeugung von MR-Daten, die die Kernmagnetisierungsverteilung im Untersuchungsbereich wiedergeben,
und daß eine Rekonstruktionseinheit (10) vorgesehen ist zur Erzeugung eines MR-Gesamtbildes aus den MR-Daten der Verarbeitungskanäle (9).

2. MR-Gerät nach Anspruch 1,
**dadurch gekennzeichnet, daß** für jede Kapazität (C_{T}) einer der beiden Leiterschleifen je ein Verarbeitungskanal (9) zur Verarbeitung der an dieser Kapazität auftretenden MR-Signale vorgesehen ist.

3. MR-Gerät nach Anspruch 1,
**dadurch gekennzeichnet**, für je zwei in einer der Leiterschleifen (81) einander benachbarten Kapazitäten (C_{T}) je eine Kombinationsschaltung (13) zur Kombination der an den beiden Kapazitäten auftretenden MR-Signale vorgesehen ist, und daß an jede Kombinationsschaltung (13) je ein Verarbeitungskanal (9) zur Verarbeitung der kombinierten MR-Signale angeschlossen ist.

4. MR-Gerät nach Anspruch 1,
**dadurch gekennzeichnet, daß** Umschalteinheiten (83,84) zur Umschaltung der Kapazitäten (C_{T}, C_{A}) der MR-Spulenanordnung (8) zwischen einer ersten und einer zweiten Betriebsart vorgesehen sind, wobei die MR-Spulenanordnung (8) in der ersten Betriebsart lediglich eine einzige Resonanzfrequenz aufweist und in der zweiten Betriebsart mehrere Resonanzmodes mit unterschiedlichen Resonanzfrequenzen, wobei der Resonanzmodus mit örtlich homogener Spulen-Empfindlichkeit bei einer Resonanzfrequenz liegt, die der einzigen Resonanfrequenz in der ersten Betriebsart entspricht.

5. MR-Spulenanordnung mit zwei gleichartigen, Kapazitäten (C_{T}) enthaltenden Leiterschleifen (81,82), die über mehrere, Kapazitäten (C_{A}) enthaltende Leiter miteinander verbunden sind.
**dadurch gekennzeichnet, daß** zum Empfangen von mehreren MR-Signalen mit einer innerhalb des von der Spulenanordnung umschlossenen Bereichs ortsabhängigen Empfindlichkeit die Kapazitäten (C_{T}, C_{A}) so bemessen sind, daß sich lediglich eine einzige Resonanzfrequenz ergibt.

## Claims

1. An MR apparatus which includes an MR coil system (8) which serves to receive MR signals from an examination zone (2) and comprises two similar conductor loops (81, 82) which include capacitances (C_{T}) and are interconnected via conductors (80) which include several capacitances (C_{A}), every two neighboring conductors and the conductor loop sections between them constituting a respective mesh,
**characterized in that** the capacitances (C_{T}, C_{A}) are dimensioned such that only a single resonance frequency occurs for all resonance modes of the MR coil system (8),
**in that** at least two processing channels (9) are provided for the separate processing of the at least two MR signals occurring in the various meshes and for generating MR data which represent the nuclear magnetization distribution in the examination zone,
and **in that** a reconstruction unit (10) is provided for forming an MR overall image from the MR data from the processing channels (9).

2. An MR apparatus as claimed in Claim 1,
**characterized in that** a respective processing channel (9) is provided for each capacitance (C_{T}) of one of the two conductor loops for processing the MR signals occurring at this capacitance.

3. An MR apparatus as claimed in Claim 1,
**characterized in that** a respective combining circuit (13) is provided for every two neighboring capacitances (C_{T}) in one of the conductor loops (81) for combining the MR signals occurring at the two capacitances, and **in that** a respective processing channel (9) is connected to each combining circuit (13) for processing the combined MR signals.

4. An MR apparatus as claimed in Claim 1,
**characterized in that** switching units (83, 84) are provided for switching the capacitances (C_{T}, C_{A}) of the MR coil system (8) between a first and a second mode of operation, the MR coil system (8) having only a single resonance frequency in the first mode of operation and several resonance modes with different resonance frequencies in the second mode of operation, the resonance mode with a locally uniform coil sensitivity lying at a resonance frequency which corresponds to the single resonance frequency in the first mode of operation.

5. An MR coil system with two similar conductor loops (81, 82) which include capacitances (C_{T}) and are interconnected via a plurality of conductors which include capacitances (C_{A}),
**characterized in that** for the reception of a plurality of MR signals with a location-dependent sensitivity within the area enclosed by the coil system the capacitances (C_{T}, C_{A}) are dimensioned such that there is only a single resonance frequency.

## Revendications

1. Appareil de RM avec un agencement de bobines de RM (8) servant à la réception des signaux de RM d'une zone d'examen (2) qui comprend deux boucles de conducteur (81, 82) contenant deux capacités similaires (CT), lesquelles sont reliées entre elles par l'intermédiaire de plusieurs conducteurs (80) contenant des capacités (CA), deux conducteurs voisins et les segments des boucles de conducteur se trouvant dans l'intervalle formant une maille,
**caractérisé en ce que** les capacités (CT, CA) sont dimensionnées de telle sorte qu'il en résulte une seule fréquence de résonance pour tous les modes de résonance de l'agencement de bobines de RM (8),
qu'au moins deux canaux de traitement (9) sont prévus pour le traitement séparé des signaux de RM enregistrés dans les deux mailles différentes au moins et pour la production de données de RM qui traduisent la distribution de la magnétisation nuclaire dans la zone d'examen,
et qu'une unité de reconstruction (10) est prévue pour la production d'une image totale de RM à partir des données de RM des canaux de traitement (9).

2. Appareil de RM selon la revendication 1,
**caractérisé en ce qu'**un canal de traitement (9) pour le traitement des signaux RM survenant sur cette capacité est respectivement prévu pour chaque capacité (CT) d'une des deux boucles de conducteur.

3. Appareil de RM selon la revendication 1,
**caractérisé en ce qu'**un circuit de combinaison (13) pour la combinaison des signaux de RM survenant aux deux capacités est respectivement prévu pour deux capacités (CT) voisines l'une de l'autre dans l'une des boucles de conducteur (81) et qu'un canal de traitement (9) est respectivement raccordé pour le traitement des signaux de RM combinés à chaque circuit de combinaison (13).

4. Appareil de RM selon la revendication 1,
**caractérisé en ce que** des unités de commutation (83, 84) sont prévues pour la commutation des capacités (CT, CA) de l'agencement de bobines de RM (8) entre des premier et deuxième modes de fonctionnement, l'agencement de bobines de RM (8) présentant seulement une fréquence de résonance unique dans le premier mode de fonctionnement et plusieurs modes de résonance avec différentes fréquences de résonance dans le deuxième mode de fonctionnement, le mode de résonance avec une sensibilité des bobines localement homogènes se situant à une fréquence de résonance qui correspond à la fréquence de résonance unique dans le premier mode de fonctionnement.

5. Agencement de bobines de RM avec deux boucles de conducteur (81, 82) similaires contenant des capacités (CT) qui sont reliées entre elles par plusieurs conducteurs contenant des capacités (CA),
**caractérisé en ce que**, pour la réception de plusieurs signaux de RM avec une sensibilité locale dans la zone renfermée par l'agencement de bobines, les capacités (CT, CA) sont dimensionnées de telle sorte qu'il en résulte seulement une fréquence de résonance unique.
